# EUROPEAN PATENT APPLICATION

(11) **EP 3 836 226 A1**
(43) Date of publication of application: **16.06.2021**
(21) Application number: 19214802.1
(22) Date of filing: 10.12.2019
(51) Int. Cl.: H01L 29/66, H01L 29/78

(54) **A METHOD FOR PROCESSING A FINFET DEVICE**

(71) Applicant: Imec VZW, 3001 Leuven (BE)
(72) Inventor: CHAN, Boon Teik, 3001 Leuven (BE); ALTAMIRANO SANCHEZ, Efrain, 3001 Leuven (BE); DENTONI LITTA, Eugenio, 3001 Leuven (BE)
(74) Representative: Roth, Sebastian

(57) **Abstract**

The present invention relates to FinFET devices. In particular, the present invention presents a method for processing a FinFET device using a metal gate cut (MGC). The method comprises: forming a plurality of fin structures on a substrate, each fin structure extending along a first direction; forming a first dielectric layer on and around the fin structures and on the substrate between the fin structures; forming a work function metal (WFM) layer on the first dielectric layer; and forming a sacrificial layer on the WFM layer. The method further comprises, for implementing the MGC, forming a first trench between two of the fin structures, by etching partially into the sacrificial layer, forming a spacer layer on each sidewall of the first trench, and extending the first trench onto the substrate, by etching entirely through the sacrificial layer and through the first dielectric layer and the WFM layer.

## Description

### TECHNICAL FIELD

In general, the present invention relates to the field of fabricating semiconductor devices. In particular, the present invention relates to a Fin Field Effect Transistor (FinFET) device. The invention provides a method for processing the FinFET device, a semiconductor structure for the FinFET device, and the FinFET device.

### BACKGROUND

Electronic devices rely heavily on the use of semiconductor memory and logic devices, which have at their core various types of transistors. For example, a typical transistor used in semiconductor memory and logic devices is the field effect transistor (FET). The FET includes a gate dielectric disposed over a semiconductor channel region, and a gate formed over the gate dielectric. A source region and a drain region are, respectively, formed on either side of the channel region.

The fact that the semiconductor industry has progressed into nanometer technology, and the continuous demand for higher device density, higher performance, and lower costs, have resulted in the development of new three dimensional (3D) transistor designs, such as the FinFET. Usually, a FinFET is fabricated by forming a "fin" (or fin-like structure), which protrudes upwards from a wafer or substrate, and extends lengthwise on the wafer or substrate along a certain direction. For example, the fin may be etched into/from the wafer or substrate. The fin forms a channel of the FinFET, in particular, the channel runs along the length of the fin. The gate dielectric and the gate are provided over the fin, in particular, they are wrapped around a section of the fin. This provides the advantage of having gate control from the top and from both sides of the channel. Advantages of the FinFET comprise less short channel effect and higher current flow.

However, as device structures become ever denser, challenges arise with the fabrication of FinFET devices that, for instance, include multiple fins and multiple gates across the fins. A particular challenge is the patterning of the gates. For the formation of gates, a sidewall image transfer process may be used. However, the gate lengths cannot be well controlled at small scale. Therefore, to for instance create shorter gates, the gates typically need to be cut (gate gut) after being formed. One goal thereby is to reduce the tip-to-tip (T2T) space between the resulting shorter gates. In fact, reducing the T2T space has become one of the biggest patterning challenges for Complementary Metal Oxide Semiconductor (CMOS) technologies.

One conventional approach to implement gate cuts are so-called poly gate cuts. In this approach, first poly dummy gates are applied over the fins, then the poly dummy gates are cut, and afterwards the cut dummy gates are transformed into functional metal gates. In order to reduce the T2T space, a further conventional approach employs a metal gate cut (MCG) instead of the poly gate cut. In this approach, the functional metal gates are directly applied over the fins, and are then separated by the MCG.

However, a MGC as used in a conventional method for processing a FinFET device has several disadvantages. Firstly, gate spacers, which are typically arranged adjacent to gates, are often damaged during the an-isotropic MGC (etch). Furthermore, a MGC without bias tends to create undercuts of gate metal. Moreover, a lot of metal has to be removed with the conventional MGC. All this can negatively impact on the yield and the performance of the FinFET device.

### SUMMARY

In view of the above-mentioned challenges and disadvantages, embodiments of the invention aim to improve a conventional method for processing a FinFET device. An objective is to reduce the T2T space by using a MGC, while avoiding the above-mentioned disadvantages. In particular, no undercutting of gate metal should occur during the MGC. Also, less metal than conventionally should be removed by the MGC. Finally, gate spacers should be better protected during the MGC.

The objective is achieved by the embodiments provided in the enclosed independent claims. Advantageous implementations of the embodiments are further defined in the dependent claims.

According to a first aspect, the invention relates to a method for processing a FinFET device, wherein the method comprises: forming a plurality of fin structures on a substrate, each fin structure extending along a first direction, forming a first dielectric layer on and around the fin structures and on the substrate between the fin structures, forming a work function metal (WFM) layer on the first dielectric layer, forming a sacrificial layer on the WFM layer, forming a first trench between two of the fin structures, by etching partially into the sacrificial layer, forming a spacer layer on each sidewall of the first trench, and extending the first trench onto the substrate, by etching entirely through the sacrificial layer and through the first dielectric layer and the WFM layer.

A "fin structure" refers to a 3D structure, which has a longish, fin-like shape, which protrudes from the substrate, and which extends (lengthwise) on the substrate into the first direction. The substrate may comprise a semiconductor layer (e.g., Si, Ge, SiGe or GaAs), from which the fin structures protrude. The substrate may further comprise Shallow Trench Isolation, STI, between the protruding fin structures. The multiple fin structures may, in particular, extend in parallel on the substrate. Each fin structure will act as a channel in the final FinFET device. One or more gate structures maybe positioned around each fin structure in the final FinFET device. Thereby, the first dielectric layer may function as a gate dielectric in the FinFET device, and the WFM layer may function as a gate metal in the FinFET device. Sections of each fin structure, on opposing sides of one or more gates, i.e., at beginning and end of each channel, may define source and drain regions of the FinFET device. The fin structures may comprise different kinds of semiconductor materials, such as silicon (Si), germanium (Ge) or a combination thereof (SiGe), or gallium arsenide (GaAs). The semiconductor layer of the substrate may comprise the same material as the fin structures, wherein the fin structures may also be patterned/etched into/from the semiconductor layer of the substrate.

The method of the first aspect provides a MGC, implemented by etching the first trench through the first dielectric layer and the WFM metal, respectively. The first trench separates these layers, thus separates gate dielectric and gate metal, and accordingly a gate. An isolation material, e.g. a dielectric material, may be filled into the trench. The MGC in this case is between two fin structures (in a direction across the fin structures).

One advantage of the method of the first aspect is that a fully self-aligned MGC can be performed, wherein the sacrificial layer may act as a hardmask. Further, there is less metal to be removed in the MGC than in a conventional method for processing a FinFET device with a MGC, in particular, since there is no thick tungsten layer (W) that has to be etched. Furthermore, the two-step etch of the trench, and the formation of the spacer after the first etch partially into the sacrificial layer, helps minimizing the undercutting of the of the WFM layer during the MGC. Thus, an improved method for processing a FinFET device is provided.

In an implementation form of the method of the first aspect, the method further comprises: forming, following the forming of the fin structures, a plurality of barrier structures, each barrier structure extending on the substrate and across the fin structures along a second direction perpendicular to the first direction, forming the first dielectric layer also on and around the barrier structures and on the substrate between the barrier structures, forming a second trench between two of the barrier structures, by etching partially into the sacrificial layer, forming the spacer layer also on the sidewalls of the second trench, and extending also the second trench onto the substrate, by the further etching of the sacrificial layer and the etching of the first dielectric layer and the WFM layer.

The etching of the second trench implements a MGC. This MGC is between two barrier structures (in a direction across the barrier structures), wherein the barrier structures may include gate spacers. Again, less metal needs to be removed as in a conventional MGC, and undercutting of the WFM layer is prevented by the spacer layer.

In an implementation form of the method of the first aspect, forming each of the barrier structures comprises: forming an oxide structure and a sidewall spacer on each side of the oxide structure, recessing the top parts of the oxide structure and the sidewall spacers, and forming a second dielectric layer on the recessed oxide structure and the sidewall spacers.

For instance, the sidewall spacers function gate spacers in the final FinFET device, and the oxide structure functions as an inter-layer dielectric (ILD). Between two adjacent barrier structures, i.e. between the sidewall spacers of the adjacent barrier structures, gates may be formed, or the MGC may be provided by forming the second trench. Optionally the second trench may filled with an isolation material, e.g. a dielectric material. By forming the second dielectric layer on the spacer layers, the spacer layers (gate spacers) are better protected during the MGC.

In an implementation form of the method of the first aspect, the top parts of the oxide structure and the sidewall spacers are recessed by 10-15 nm.

Accordingly, a 10-15 nm second dielectric layer may be formed, e.g., by growth, in the recesses. This provides sufficient protection of the sidewall spacers during the MGC.

In an implementation form of the method of the first aspect, the first dielectric layer and the second dielectric layer comprise the same dielectric material.

In an implementation form of the method of the first aspect, the first dielectric layer comprises a high-k material layer and/or a HfO₂ layer.

These materials may function well as (thin) gate dielectrics.

In an implementation form of the method of the first aspect, the WFM layer comprises a p-type WFM layer and/or a TiN layer.

These materials may function well as (thin) gate metals. A further gate metal may be applied after the MGC onto the WFM layer.

In an implementation form of the method of the first aspect, the WFM layer further comprises a W layer, formed by Atomic Layer Deposition (ALD) on the WFM layer and/or on the TiN layer.

This may be advantageous for forming the gate, but the ALD provides a very thin tungsten (W) layer, so that the amount of metal to be removed by the MGC is still rather small, in particular, much smaller than in a conventional method for processing a FinFET device.

In an implementation form of the method of the first aspect, the spacer layer comprises a high-k material layer and/or a HfO₂ layer.

This provides the advantage that the etch resistance during the an-isotropic MGC etch is enhanced.

In an implementation form of the method of the first aspect, the sacrificial layer comprises a spin-on-carbon (SOC) and/or a spin-on-glass (SOG) layer.

These materials can be easily patterned and may thus advantageously serve as hardmask during the MGC etch forming the first and/or second trench.

In an implementation form of the method of the first aspect, the method further comprises: depositing a filling material into the first trench and/or into the second trench.

In an implementation form of the method of the first aspect, the filling material comprises Si₃N₄, SiOCN, SiC, SiON, or SiCO.

These materials provide good isolation between the gates, and thus support reducing the T2T space.

In an implementation form of the method of the first aspect, the method further comprises: completely removing the sacrificial layer, after extending the first trench, and forming a metal layer, in particular a tungsten layer, on the thus exposed WFM layer.

Thus, a further gate metal is provided, and the gates can be completed. Since the tungsten is provided after the MGC, this amount of metal does not have to be removed in the MGC.

In an implementation form of the method of the first aspect, the metal layer is formed only between the barrier structures.

In particular, the metal layer, particularly tungsten layer, may be formed between a spacer layer of one barrier structure, and an adjacent spacer layer of an adjacent barrier structure. Thus, a gate is formed between these spacer layers acting as gate spacers.

According to a second aspect, the invention relates to a structure for a FinFET device, the structure comprising: a plurality of fin structures arranged on a substrate, each fin structure extending along a first direction, a first dielectric layer arranged on and around the fin structures and arranged on the substrate between the fin structures, a work function metal, WFM, layer arranged on the first dielectric layer, a sacrificial layer arranged on the WFM layer, a first trench formed in the sacrificial layer between two of the fin structures, wherein the first trench extends only in an upper part of the sacrificial layer, and a spacer layer provided on each sidewall of the first trench.

This structure ensures that the final FinFET device shows less undercutting of gate metal caused by the MGC, and thus can be fabricated with less T2T space and shorter gate lengths.

According to a third aspect, the invention relates to a FinFET device fabricated using the method according to the first aspect.

Such a FinFET device produced with the method of the first aspect shows clear "fingerprints" of that method. The FinFET device may have smaller T2T space than a conventional FinFET device. Further, due to less gate spacer damage, less undercutting of gate metal during MGC, and less metal that needs to be removed during the MGC, the FinFET device can be fabricated with a better yield.

### BRIEF DESCRIPTION OF DRAWINGS

The above described aspects and implementation forms of the present invention will be explained in the following description of specific embodiments in relation to the enclosed drawings, in which:
- FIG. 1: shows steps of a general method for processing a FinFET device, according to an embodiment.
- FIG. 2: shows further steps of the general method for processing the FinFET device, according to an embodiment.
- FIG. 3: shows steps of an exemplary detailed method for processing the FinFET device, according to an embodiment.
- FIG. 4: shows further steps of the exemplary detailed method for processing the FinFET device, according to an embodiment.
- FIG. 5: shows further steps of the exemplary detailed method for processing the FinFET device, according to an embodiment.
- FIG. 6: shows further steps of the exemplary detailed method for processing the FinFET device, according to an embodiment.
- FIG. 7: shows further steps of the exemplary detailed method for processing the FinFET device, according to an embodiment.
- FIG. 8: shows further steps of the exemplary detailed method for processing the FinFET device, according to an embodiment.
- FIG. 9: shows further steps of the exemplary detailed method for processing the FinFET device, according to an embodiment.
- FIG. 10: shows further steps of the exemplary detailed method for processing the FinFET device, according to an embodiment.
- FIG. 11: shows further steps of the exemplary detailed method for processing the FinFET device, according to an embodiment.
- FIG. 12: shows further steps of the exemplary detailed method for processing the FinFET device, according to an embodiment.
- FIG. 13: shows further steps of the exemplary detailed method for processing the FinFET device, according to an embodiment.
- FIG. 14: shows further steps of the exemplary detailed method for processing the FinFET device, according to an embodiment.
- FIG. 15: shows further steps of the exemplary detailed method for processing the FinFET device, according to an embodiment.
- FIG. 16: shows further steps of the exemplary detailed method for processing the FinFET device, according to an embodiment.
- FIG. 17: shows further steps of the exemplary detailed method for processing the FinFET device, according to an embodiment.
- FIG. 18: shows further steps of the exemplary detailed method for processing the FinFET device, according to an embodiment.
- FIG. 19: shows further steps of the exemplary detailed method for processing the FinFET device, according to an embodiment.

### DETAILED DESCRIPTION OF EMBODIMENTS

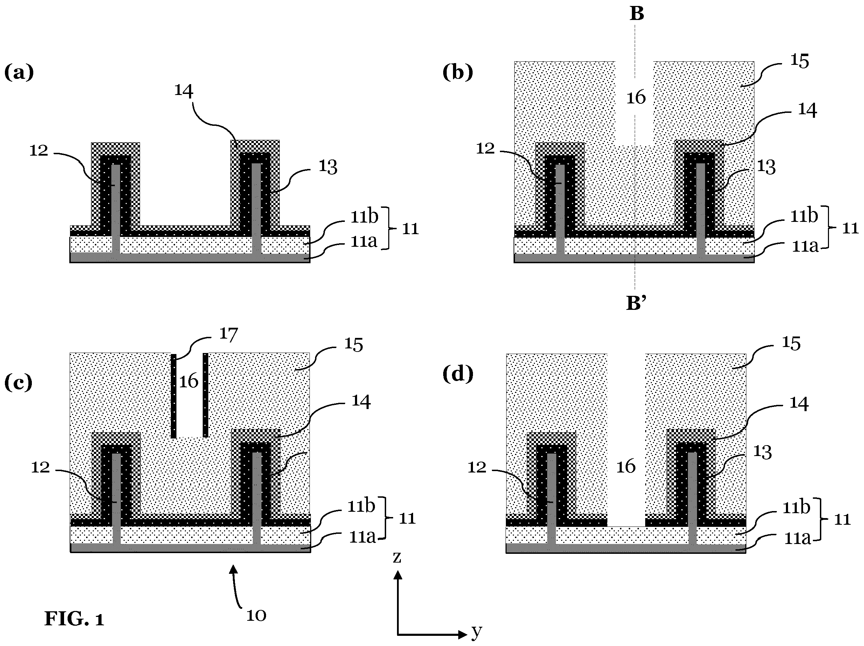

FIG. 1 shows a general method for processing a FinFET device according to an embodiment. In particular, the main steps for performing a MGC in the method are illustrated.

The method comprises, as shown in FIG. i(a), forming a plurality of fin structures 12 on a substrate 11, wherein each fin structure 12 extends along a first direction, here along the x-direction. The substrate 11 may comprise a semiconductor (material) layer 11a, on which the fin structures are formed (or in which they are formed). The substrate 11 may further comprise STI 11b arranged between adjacent fin structures 12. That is, the semiconductor layer 11a and an STI layer 11b may constitute the substrate 11. The x-direction is perpendicular to the z-direction, wherein the z-direction is in-line with the direction of layer fabrication, and the x-direction is also perpendicular to the y-direction, as indicated by the schematic coordinate system. The x-direction extends into the plane of FIG. 1. Further, the method also comprises forming a first dielectric layer 13 (e.g., a high-k material layer and/or a HfO₂ layer) on and around the fin structures 12, and on the substrate 11 between the fin structures 12, e.g. on the STI 11b between the fin structures. The first dielectric layer 13 may function as gate dielectric in the final FinFET device. Further, the method also comprises forming a WFM layer 14 (e.g., a p-type WFM layer and/or a TiN layer) on the first dielectric layer 13. The WFM layer 14 may function as gate metal in the final FinFET device.

As shown in FIG. i(b), the method then comprises forming a sacrificial layer 15 (e.g., a SOC layer and/or SOG layer) on the WFM layer 14. The method also comprises forming a first trench 16 or via 16 between two of the fin structures 12, by etching partially into the sacrificial layer 15.

As shown in FIG. i(c), the method then comprises forming a spacer layer 17 (e.g., a high-k material layer and/or an HfO₂ layer) on each sidewall of the first trench 16. This spacer layer 17 protects from undercutting the WFM layer 14 during the MGC.

Notably, after the step performed in FIG. i(c), a structure 10 (in particular, an intermediate FinFET device) according to an embodiment of the invention is obtained. The structure 10 comprises: the plurality of fin structures 12 arranged on the substrate 11, 11a, 11b; the first dielectric layer 13 arranged on and around the fin structures 12 and arranged on the substrate 11, 11a, 11b between the fin structures 12; the WFM layer 14 arranged on the first dielectric layer 13; the sacrificial layer 15 arranged on the WFM layer 14; the first trench 16 formed in the sacrificial layer 15 between two of the fin structures 12, wherein the first trench 16 extends only in an upper part of the sacrificial layer 15; and the spacer layer 17 provided on each sidewall of the first trench 16.

As shown in FIG. 1(d), the method then comprises extending the first trench 16 onto the substrate 11, e.g. onto the STI 11b, by etching entirely through the sacrificial layer 15 and through the first dielectric layer 13 and the WFM layer 14, respectively, thus completing the MGC. Thereby, also the spacer layer 17 is removed.

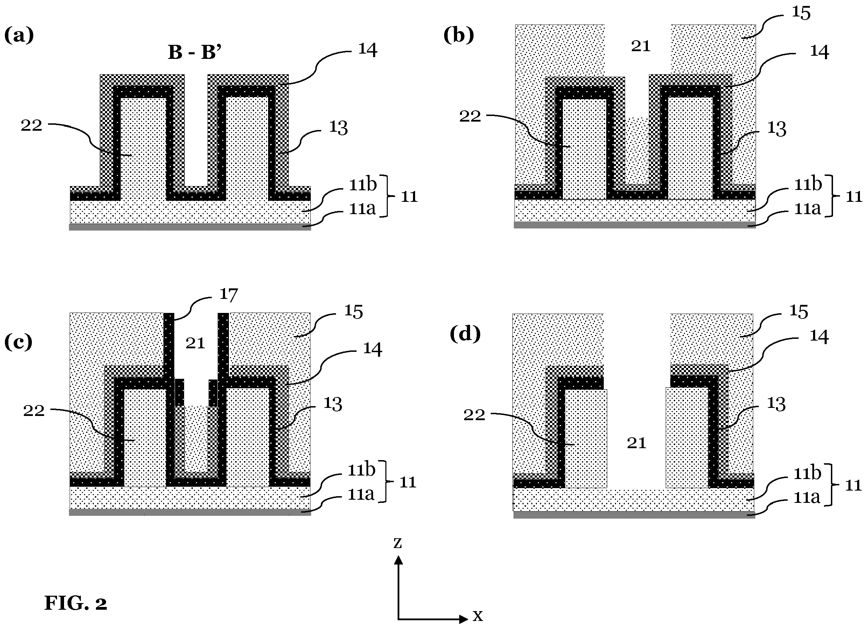

FIG. 2 shows further steps (in particular some performed in parallel with the steps performed in FIG. 1) of the general method for processing a FinFET device according to an embodiment. In particular, the main steps for performing another MGC in the method are illustrated.

The method further comprises, as shown in FIG. 2(a), forming, following the forming of the fin structures 12 (see FIG. 1), a plurality of barrier structures 22, each barrier structure 22 extending on the substrate 11 and across the fin structures 12 along a second direction that is perpendicular to the first direction. Here the second direction is the y-direction, which extends into the plane in FIG. 2. The z-direction and x-direction, which is the extension direction of the fin structures 12 on the substrate 11, are perpendicular as indicated by the schematic coordinate system. Further, the method comprises forming the first dielectric layer 13 also on and around the barrier structures 22, and on the substrate 11 between the barrier structures 22, e.g. STI 11b between the barrier structures.

As shown in FIG. 2(b), the sacrificial layer 15 is formed as in FIG. 1, and the method comprises forming a second trench 21 between two of the barrier structures 22, by etching partially into the sacrificial layer 15. The second trench 21 may extend parallel to the barrier structures 22, and thus perpendicular to the first trench 16. In the case, which is exemplarily illustrated, a gate pitch for the FinFET device is quite small, and accordingly the barrier structures 22 are quite close together. In particular, a gap between the two adj acent barrier structures 22 exemplarily shown, is narrower than the width of the second trench 21. Thus, the second trench 21 narrows between the barrier structures 22 to the width of the gap. However, if the gate pitch for the FinFET device is selected larger, and the barrier structures 22 are accordingly wider apart, this does not have to be the case.

As shown in FIG. 2(c), the method further comprises forming the spacer layer 17 also on the sidewalls of the second trench 21 or via 21, again to avoid undercutting of the WFM layer 14. In the exemplary case illustrated, the WFM layer 14 is removed, where it is inside the second trench 21, before/by the forming of the spacer layer 17. Thus, the spacer layer 17 and the first dielectric layer 13 touch inside the second trench 21.

As shown in FIG. 2(d), the method further comprises extending also the second trench 21 onto the substrate 11, e.g. onto the STI 11b, by the further etching of the sacrificial layer 15 and the etching of the first dielectric layer 13 and the WFM layer 14, thus completing another MGC. Thereby, also the spacer layer 17 is removed.

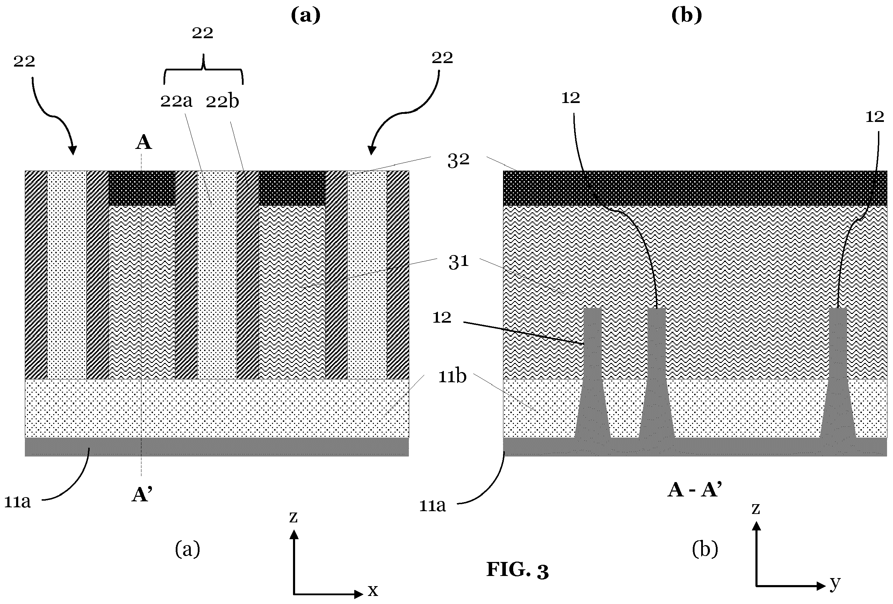

FIGs. 3-18 show more, exemplary, details of the method shown in FIG. 1 and FIG. 2. That is, an exemplary detailed method according to an embodiment of the invention is illustrated. The method obtains a FinFET device according to an embodiment of the invention. In each of the FIGs. 3-18, (a) shows a cross-section of the respective intermediate structure for the FinFET device in the z-x plane, i.e. across the barrier structures 22, while (b) shows a cross-section of the same respective intermediate structure in the z-y plane, i.e. across the fin structures 12.

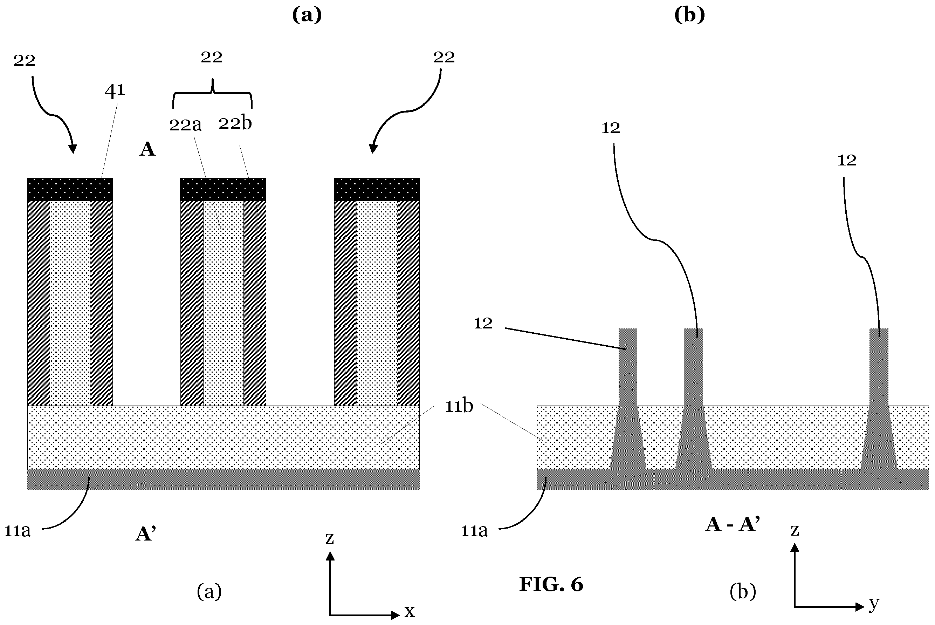

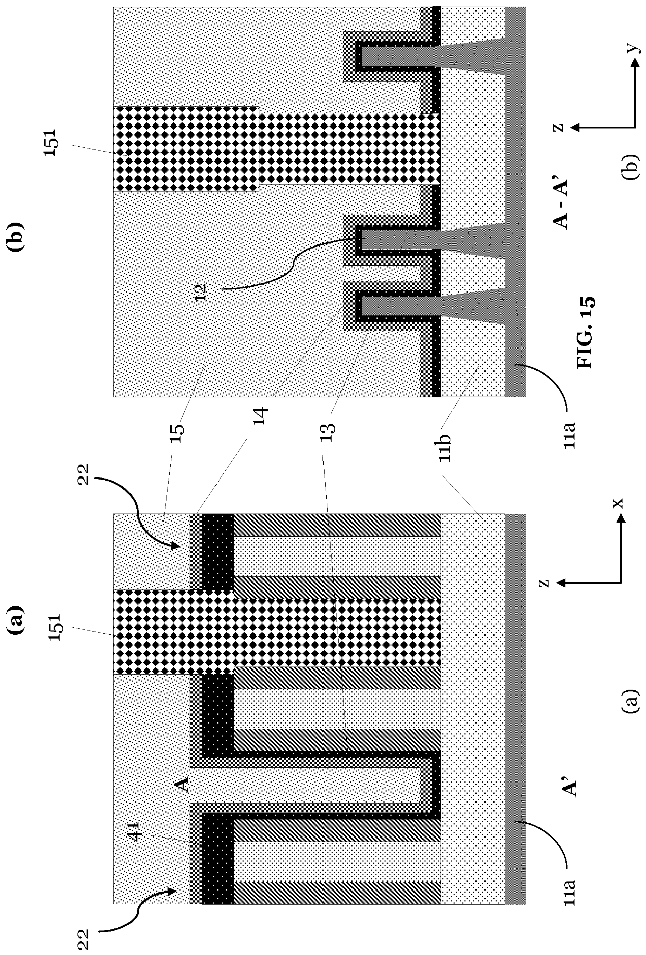

Notably, the FIGs. 3-5 show method steps that can be used for the forming of the plurality of fin structures 12 shown in FIG. i(a), and for the forming of the plurality of barrier structures 22 shown in FIG. 2(a). The FIGs. 15-19 show method steps that can be applied after the MGCs, i.e. after the extending of the first trench 16 and the second trench 21 shown in FIG. i(d) and FIG. 2(d), respectively. The FIGs. 6-14 show method steps including the method steps shown in FIG. i(a)-(d) and FIG. 2(a)-(d), respectively.

In general, Fig. 3(b) shows a structure that includes the fin structures 12 arranged on the substrate 11. The substrate 11 may comprise STI 11b (as shown). The fin structures 12 are in this case separated by the STI 11b. In particular, a STI layer 11b of the substrate 11 (in this example a FCVD oxide) is formed on a semiconductor layer 11a of the substrate 11, and the fin structures 12 extend through the STI layer 11a. The fin structures 12 may be of the same material as the semiconductor layer 11a, and may even be formed integrally with the semiconductor layer 11. Furthermore, dummy gate layers 31 (in this example a polysilicon (poly-Si) layer) are formed on the STI layer 11b and over the fin structures 12. Moreover, hardmask (HM) layers 34 (in this example Si₃N₄) are formed over the dummy gate layers 31.

Fig. 3(a) shows that the structure further includes the plurality of barrier structures 22, which are arranged on the substrate 11, in particular on the STI layer 11b. The plurality of structures 22 include an ILD 22a (in this example an oxide structure, e.g. SiO2) and sidewall spacers 22b (in this example gate spacers; comprising SiCO) arranged on each side of the ILD 22a. Beneath each ILD 22a may be provided an epitaxial layer. Furthermore, the dummy gate layers 31 and the HM layers 34 form dummy gates, wherein each dummy gate is arranged between two adjacent barrier structures 22.

In particular, FIG. 3 shows the structure after a step of ILD chemical mechanical polishing (CMP), which was applied for planarizing the ILD 22a.

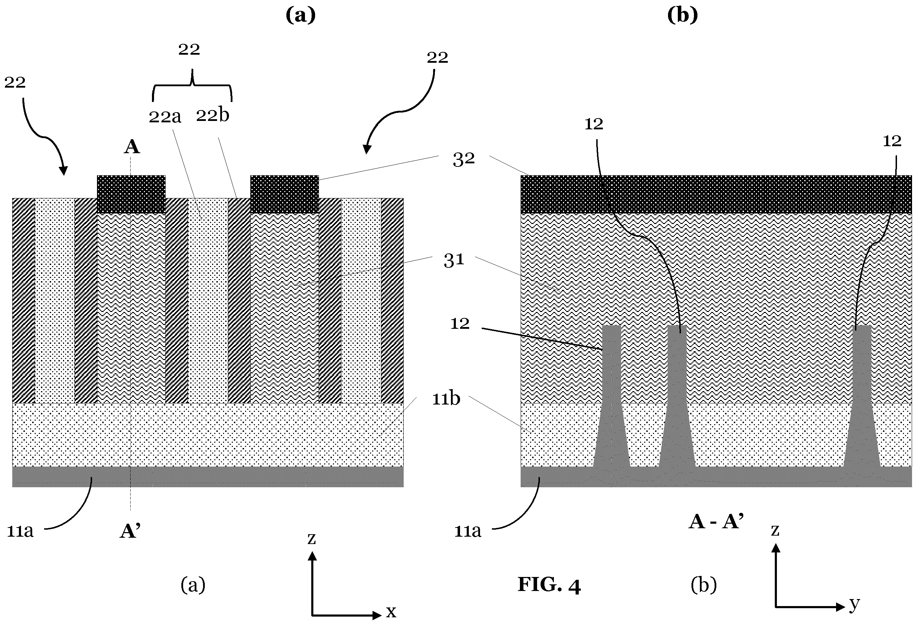

Fig. 4 shows the structure after a step of recessing the plurality of barrier structures 22, in particular, recessing the top parts of the ILD layer 22a and sidewall spacers 22b, respectively, thus forming recessed regions between the HM 34 layers (see FIG. 4(a)). The ILD oxide layer 7 can comprise SiO₂. The recess can be in the range of 10-15 nm deep into the ILD layer 22a and sidewall spacers 22b, respectively.

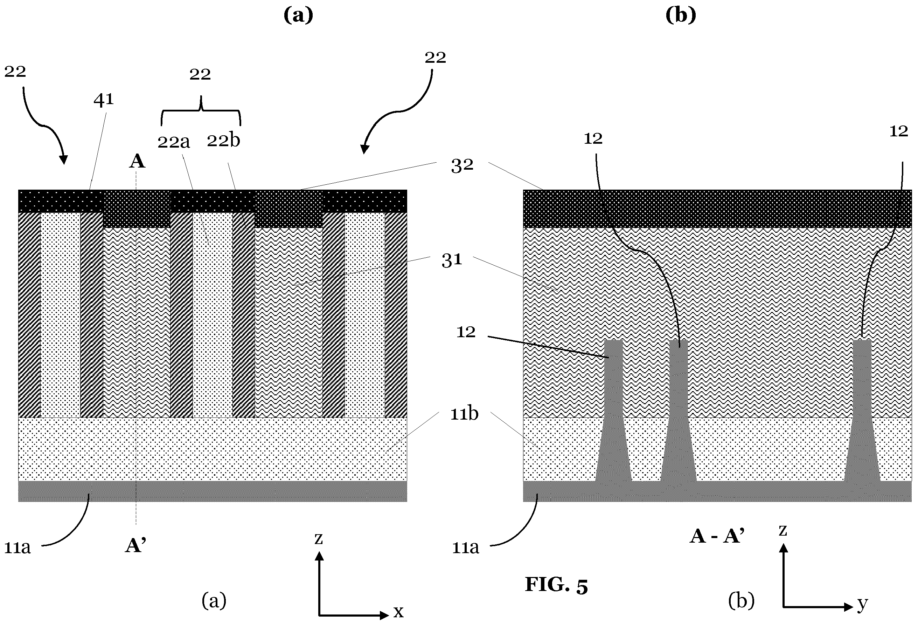

Fig. 5 shows the structure after deposition of a dielectric layer 41 (in this example HfO₂) into the recessed regions (see FIG. 5(a)), i.e., onto the ILD 22a and sidewall spacers 22b. Further, a CMP, which is selective to the HM layers 34, may be performed. The dielectric layer 41 may have a height in the range of 5-15 nm.

Fig. 6 shows the structure after removing the dummy gate layers 31 and HM layers 34. Thus, the fin structures 12 are completely exposed (FIG. 6(b)). Likewise, also the barrier structures 22 are exposed (FIG. 6(a)). The removing of the dummy gate layers 34 and HM layers 31 can be done by dry and/or wet etching.

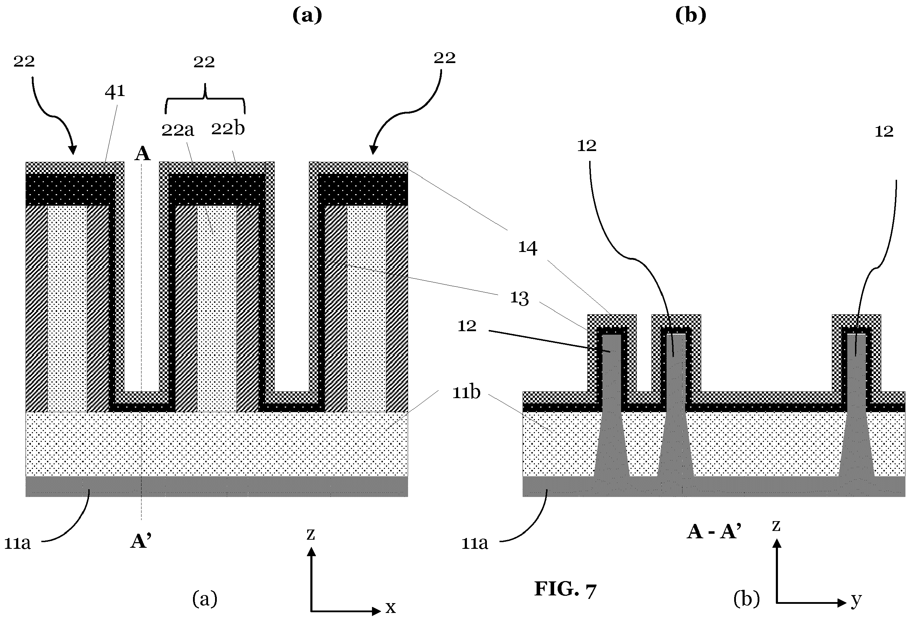

FIG. 7 shows the structure after forming the dielectric layer 13 (in this example HfO₂) on and around the fin structures 12 and on the substrate 11 between the fin structures 12 (FIG. 7(b)); and forming the dielectric layer 13 on the barrier structures 22 and on the substrate 11 between the barrier structures 22 (FIG. 7(a)), in particular on the STI layer 11b between the barrier structures. Further, also the WFM layer 14 (in this example TiN) has been formed on the dielectric layer 13. Optionally, after forming the WFM layer 14, a tungsten (W) layer (not shown) can be formed by ALD on the WFM layer 14.

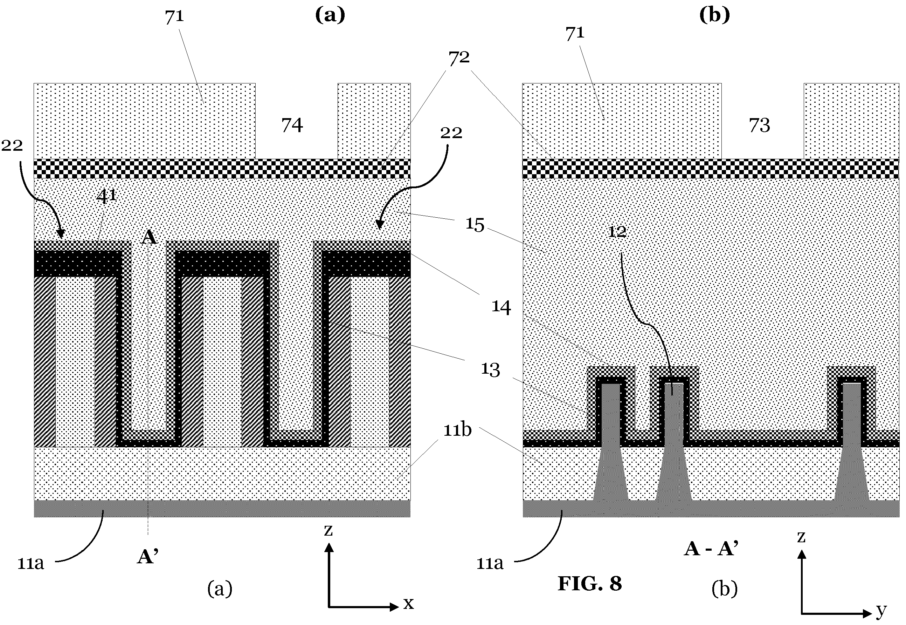

FIG. 8 shows the structure after forming a sacrificial layer 15, 72 on the WFM layer 14 (or optionally the ALD tungsten layer, if present). In this example, the sacrificial layer 15, 72 comprises a SOC layer 15 (e.g., high temperature SOC that can withstand 400°C) and/or a SOG layer 72. Further, a photoresist (PR) material 71 is deposited on the SOG layer 72. Via lithography, an opening 73 (FIG. 8(a)) and an opening 74 (FIG. 8(b)) are provided in the PR material 71. The opening 73 is arranged between two fin structures 12 (in y-direction) and the opening 74 is arranged between two barrier structures 22 (in x-direction).

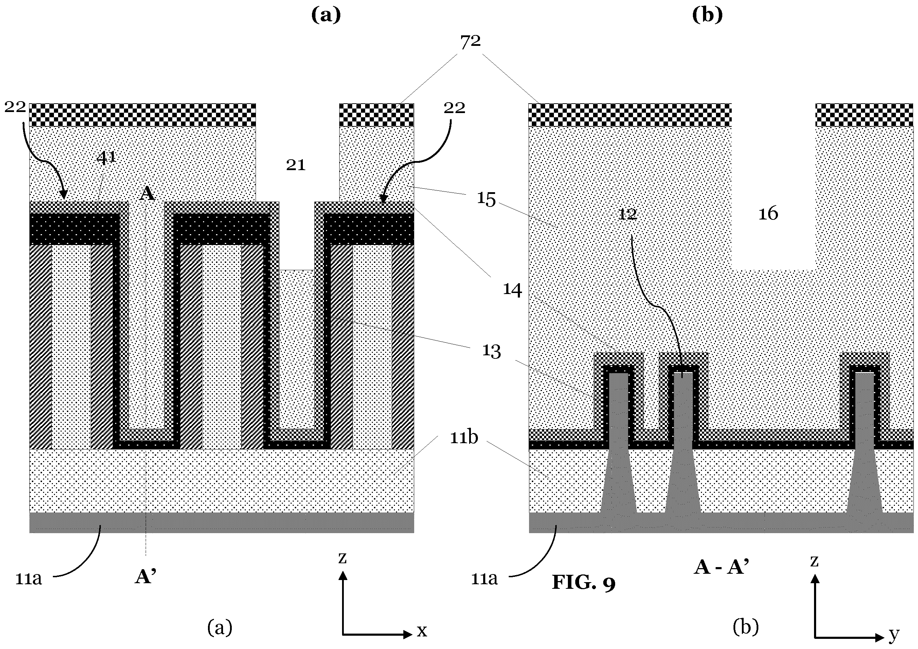

FIG. 9 shows the structure after forming the first trench 16 (FIG. 9(a)) through the opening 73, formed by etching through the SOG 72 and partially into the SOC 15, and after forming the second trench 21 (FIG. 9(a)) through the opening 74, formed by the same partial etching. In particular, the partial etching is done such that the first trench 16 ends above the fin structures 12. The PR material 13 is removed in this step.

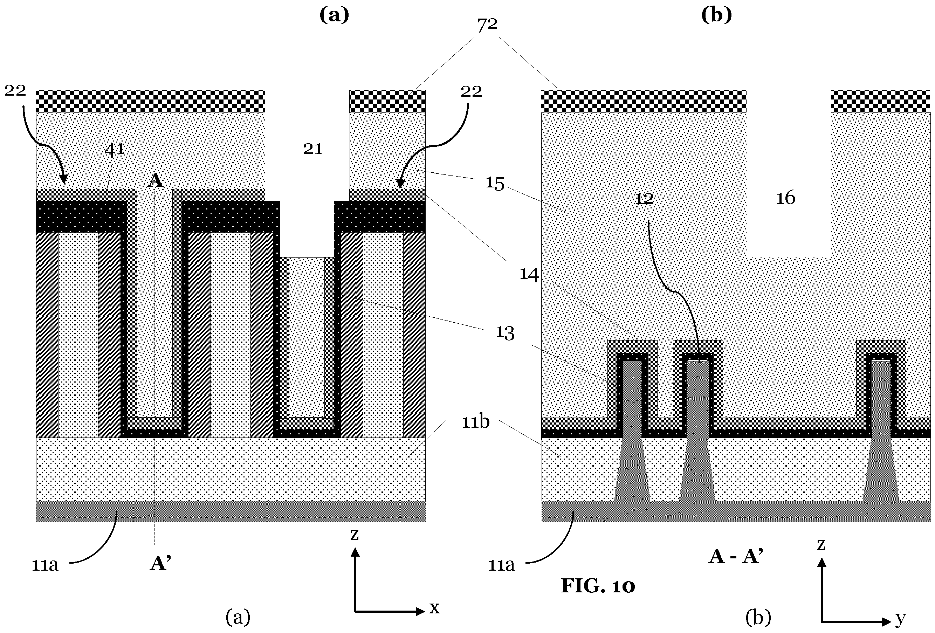

FIG. 10 shows the structure after a digital etch (optionally a dry etch), wherein the WFM layer 14 is partially removed from the sidewall spacers 22b (in fact, from the dielectric materials 13 and 41 arranged on the side wall spacers 22b).

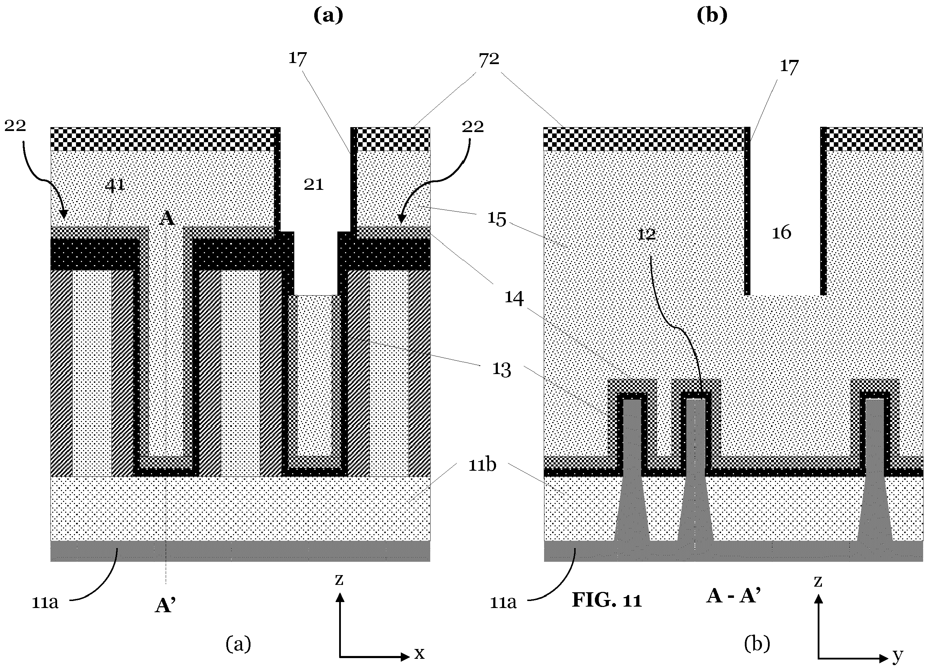

FIG. 11 shows the structure after forming the spacer layer 17 on each sidewall of the first trench 16, and forming the spacer layer 17 also on the sidewalls of the second trench 21. The spacer 17 protects the sacrificial layer 15 and minimizes undercutting of the WFM layer 14 in the further steps, particularly in the second trench 21.

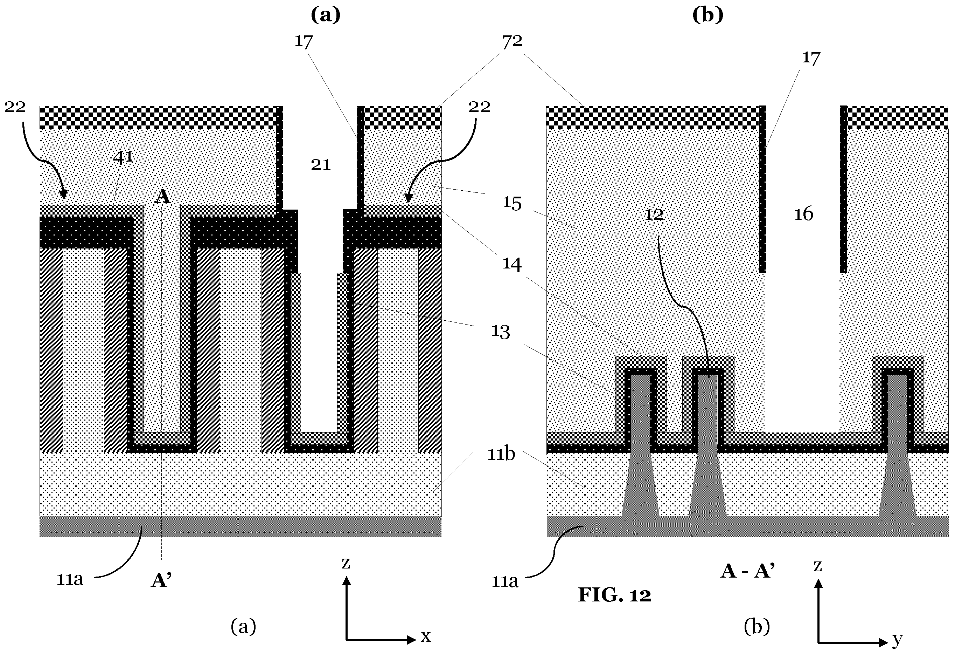

FIG. 12 shows the structure after extending the first trench 16 and the second trench 21, respectively, onto the WFM layer 14 above the substrate 11, by etching entirely through the sacrificial layer 15.

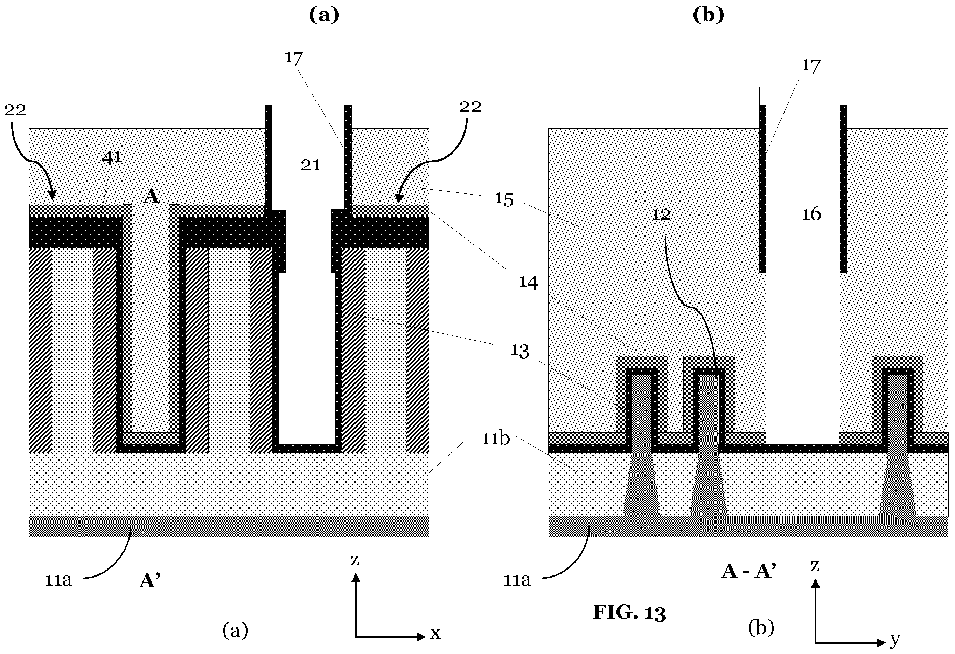

FIG. 13 shows the structure after extending the first trench 16 and the second trench 21, respectively, onto the dielectric layer 13 on the substrate 11, by etching through the WFM layer 14 on the dielectric layer 13.

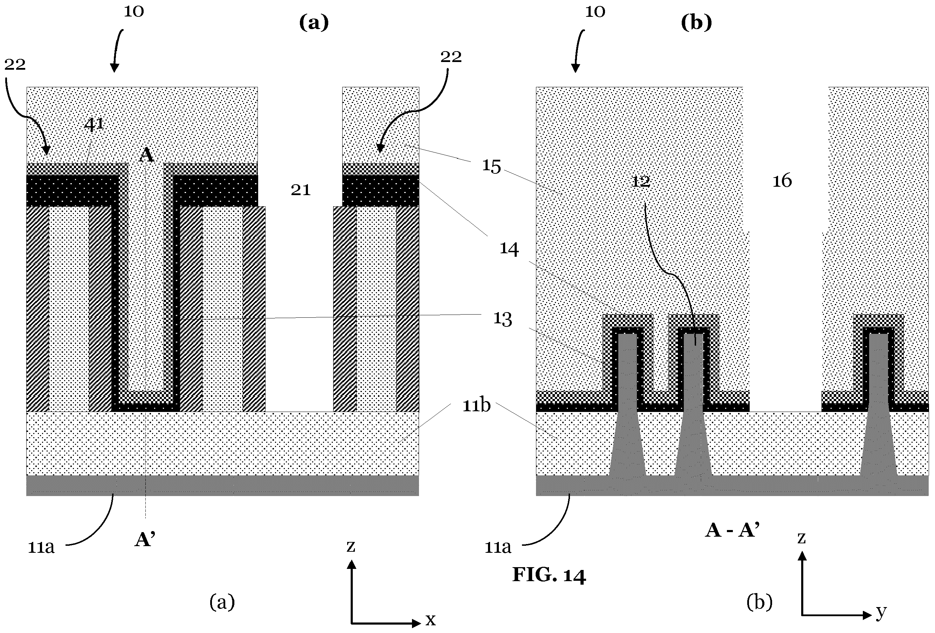

FIG. 14 shows the structure after extending the first trench 16 and the second trench 21, respectively, onto the substrate 11, in particular onto the STI layer 11b, by etching through the first dielectric layer 13 on the substrate 11. This completes the MGC, as it is similarly shown in FIG. i(d) and FIG. 2(d) for the general method. Accordingly, the structure 10 according to an embodiment is obtained.

FIG. 15 shows the structure after depositing a filling material 151 (in this example Si₃N₄, SiOCN, SiC, SiON, or SiCO) into the first trench 16 and/or into the second trench 21. After deposition of the filling material 151, CMP maybe performed.

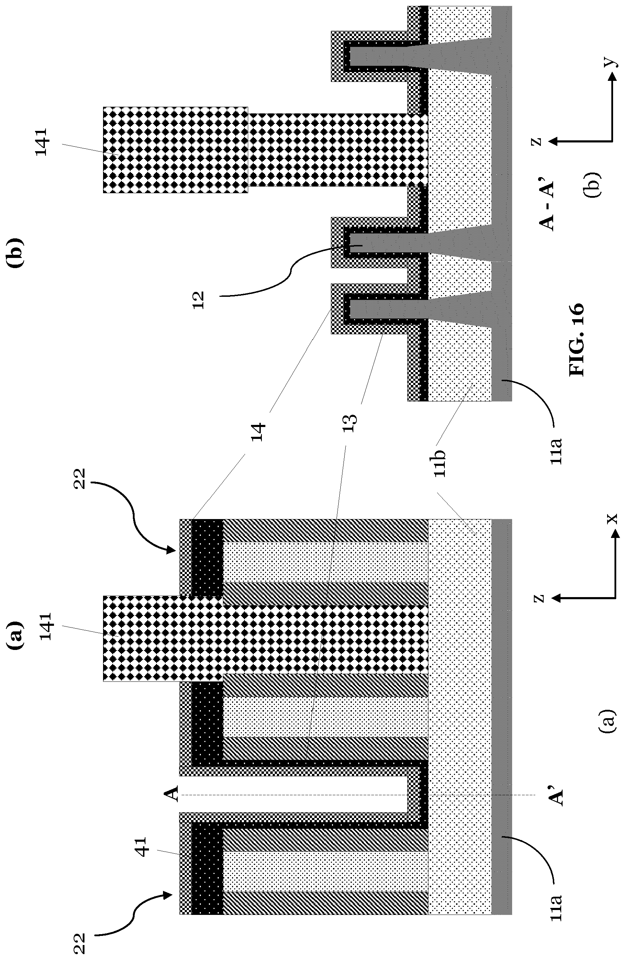

FIG. 16 shows the structure after completely removing the sacrificial layer 15, 72, in particular stripping the SOC 15 after extending the first trench 16.

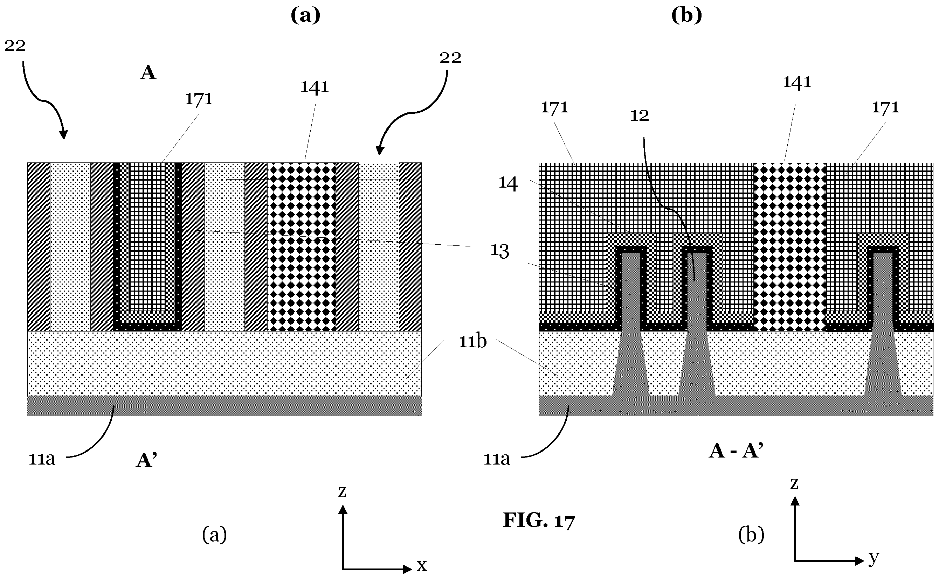

FIG. 17 shows the structure after forming a metal layer 171 (in this example a tungsten layer), on the WFM layer 14 that is exposed by the stripping of the SOC 15. A CMP of the metal layer 171 may be performed, stopping on the sidewall spacers 22b. The metal layer 171 together with the WFM layer 14 and the dielectric layer 13, which are arranged on and around the fin structures 12, may form gate structures. The metal layer 171 may be formed only between the barrier structures 22 (FIG. 17(a)).

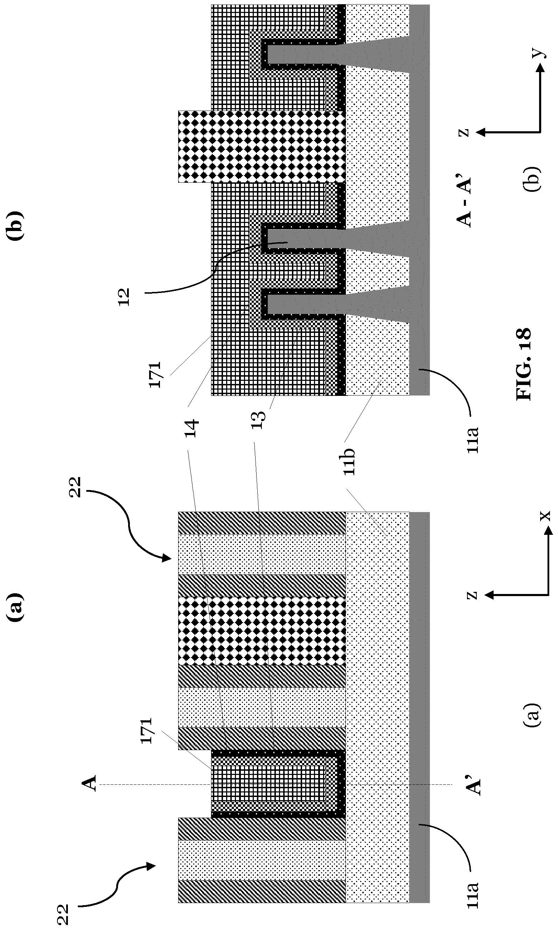

FIG. 18 shows the structure after recessing the metal layer 171, i.e. recessing the gates, in order to form recessed gates.

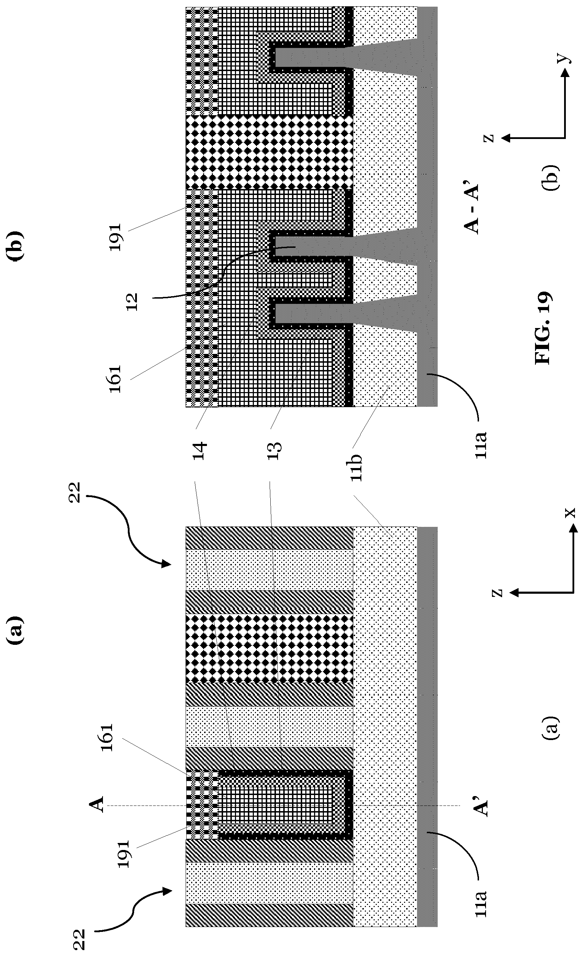

FIG. 19 shows the final FinFET device. The FinFET device is shown after filling the recessed gates with a capping material layer 191 (in this example Si₃N₄).

In summary, the embodiments of the invention (i.e. the method, the structure 10, and the FinFET device) achieve multiple advantages. Less metal needs to be cut/etched (due to the fact that no tungsten layer is applied onto the WFM layer 14 before the MGC, or only a very thin ALD tungsten layer is applied). As a consequence, also no partial tungsten CMP is required. Further, an adjustable dielectric layer 41/13 on the top of the sidewall spacers 22b (gate spacers) enhances the etch resistance of these sidewall spacers 22b during the an-isotropic MGC. Further, the spacer layer 17 provided on the sacrificial layer 15, 72, particularly the SOC 15, can minimize undercutting of the WFM layer 14 (optionally with ALD tungsten layer on top) during the MGC. This is beneficial for small gate lengths. The partial etch of the sacrificial layer 15 further allows removing the WFM layer 14 (and optionally the ALD tungsten layer) from the sidewalls of the sidewall spacers 22b. The MGC is further fully self-aligned. Finally, a gate recess (recess of metal layer 171) is after the MGC and filling material 151 deposition.

The present invention has been described in conjunction with various embodiments, as examples, as well as aspects and implementations. However, other variations can be understood and effected by those skilled in the art and practicing the claimed invention, from the studies of the drawings, this disclosure and the independent claims. In the claims as well as in the description the word "comprising" does not exclude other elements or steps and the indefinite article "a" or "an" does not exclude a plurality.

## Claims

1. A method for processing a FinFET device, wherein the method comprises:
- forming a plurality of fin structures (12) on a substrate (11, 11a, 11b), each fin structure (12) extending along a first direction;
- forming a first dielectric layer (13) on and around the fin structures (12) and on the substrate (11, 11a, 11b) between the fin structures (12);
- forming a work function metal, WFM, layer (14) on the first dielectric layer (13);
- forming a sacrificial layer (15, 72) on the WFM layer (14);
- forming a first trench (16) between two of the fin structures (12), by etching partially into the sacrificial layer (15, 72);
- forming a spacer layer (17) on each sidewall of the first trench (16); and
- extending the first trench (16) onto the substrate (11, 11a, 11b), by etching entirely through the sacrificial layer (15, 72) and through the first dielectric layer (13) and the WFM layer (14).

2. The method according to claim 1, wherein the method further comprises
- forming, following the forming of the fin structures (12), a plurality of barrier structures (22), each barrier structure (22) extending on the substrate (11, 11a, 11b) and across the fin structures (12) along a second direction perpendicular to the first direction;
- forming the first dielectric layer (13) also on and around the barrier structures (22) and on the substrate (11, 11a, 11b) between the barrier structures (22);
- forming a second trench (21) between two of the barrier structures (22), by etching partially into the sacrificial layer (15, 72);
- forming the spacer layer (17) also on the sidewalls of the second trench (21); and
- extending also the second trench (21) onto the substrate (11, 11a, 11b), by the further etching of the sacrificial layer (15, 72) and the etching of the first dielectric layer (13) and the WFM layer (14).

3. The method according to claim 2, wherein forming each of the barrier structures (22) comprises:
- forming an oxide structure (22a) and a sidewall spacer (22b) on each side of the oxide structure (22);
- recessing the top parts of the oxide structure (22a) and the sidewall spacers (22b); and
- forming a second dielectric layer (41) on the recessed oxide structure (22a) and the sidewall spacers (22b).

4. The method according to claim 3, wherein:
the top parts of the oxide structure (22a) and the sidewall spacers (22b) are recessed by 10-15 nm.

5. The method according to one of the claims 3 to 4, wherein:
the first dielectric layer (13) and the second dielectric layer (41) comprise the same dielectric material.

6. The method according to any one of the preceding claim, wherein:
the first dielectric layer (13) comprises a high-k material layer and/or a HfO₂ layer.

7. The method according to any one of the preceding claims, wherein:
the WFM layer (14) comprises a p-type WFM layer and/or a TiN layer.

8. The method according to claim 7, wherein:
the WFM layer (14) further comprises a W layer, formed by Atomic Layer Deposition, ALD, on the WFM layer (14) and/or on the TiN layer.

9. The method according to one of the claims 1 to 8, wherein:
the spacer layer (17) comprises a high-k material layer and/or a HfO₂ layer.

10. The method according to one of the claims 1 to 9, wherein:
the sacrificial layer (15, 72) comprises a spin-on-carbon, SOC, layer (15) and/or a spin-on-glass, SOG, layer (72).

11. The method according to one of the claims 1 to 10, further comprising:
- depositing a filling material (151) into the first trench (16) and/or into the second trench (21).

12. The method according to claim 11, wherein:
the filling material (151) comprises Si₃N₄, SiOCN, SiC, SiON, or SiCO.

13. The method according to one of the claims 1 to 12, further comprising:
- completely removing the sacrificial layer (15, 72), after extending the first trench (16); and
- forming a metal layer (171), in particular a tungsten layer, on the thus exposed WFM layer (14).

14. The method according to claim 13, when depending on one of the claims 2 to 5, wherein:
the metal layer (171) is formed only between the barrier structures (22).

15. A structure (10) for a FinFET device, the structure (10) comprising:
- a plurality of fin structures (12) arranged on a substrate (11, 11a, 11b), each fin structure (12) extending along a first direction;
- a first dielectric layer (13) arranged on and around the fin structures (12) and arranged on the substrate (11, 11a, 11b) between the fin structures (12);
- a work function metal, WFM, layer (14) arranged on the first dielectric layer (13);
- a sacrificial layer (15, 72) arranged on the WFM layer (14);
- a first trench (16) formed in the sacrificial layer (15, 72) between two of the fin structures (12), wherein the first trench (16) extends only in an upper part of the sacrificial layer (15, 72);
- a spacer layer (17) provided on each sidewall of the first trench (16).
